(19) **Europäisches Patentamt European Patent Office Office européen des brevets**

(11) **EP 1 382 976 B1**

(12) **EUROPEAN PATENT SPECIFICATION**

(45) Date of publication and mention
of the grant of the patent:
**28.02.2007 Bulletin 2007/09**

(51) Int Cl.:
***G01R 31/3183*** *(2006.01)*

(21) Application number: **02090272.2**

(22) Date of filing: **19.07.2002**

(54) **Method of processing test patterns for an integrated circuit**

Verfahren zur Bearbeitung von Testmustern für einen integrierten Schaltkreis

Méthode de traitement des configurations d'essais pour un circuit intégré

(84) Designated Contracting States:
**DE GB IE**

(43) Date of publication of application:
**21.01.2004 Bulletin 2004/04**

(73) Proprietor: **Infineon Technologies AG**
**81669 München (DE)**

(72) Inventor: **Liau, Eric**
**80339 München (DE)**

(74) Representative: **Rummler, Felix et al**
**Patentanwälte Maikowski & Ninnemann,**
**Postfach 15 09 20**
**10671 Berlin (DE)**

(56) References cited:
**US-A- 5 684 946**

• **SHIYOU ZHAO ET AL: "Estimation of switching noise on power supply lines in deep sub-micron CMOS circuits" VLSI DESIGN, 2000. THIRTEENTH INTERNATIONAL CONFERENCE ON CALCUTTA, INDIA 3-7 JAN. 2000, LOS ALAMITOS, CA, USA,IEEE COMPUT. SOC, US, 3 January 2000 (2000-01-03), pages 168-173, XP010365932 ISBN: 0-7695-0487-6**
• **CHAKRADHAR S T ET AL.: "Automatic test generation using neural networks" IEEE COMPUT. SOC. PRESS, IEEE CAT. NO. 88CH2657-5, ICCAD-88, DIGEST OF TECHNICAL PAPERS, ISBN 0-8186-0869-2, 1988, pages 416-419, XP000040399**
• **DATABASE [Online] October 2000 ANONYMOUS: 'Neural Network Toolbox 4', XP001152219 Retrieved from HTTP: //WWW.MATHWORKS.COM/ACADEMIA/ STUDENT_V ERSION/R14SP1_PRODUCTS/ NEURALNET/NN.PDF**
• **DATABASE [Online] 25 October 1996 SMITH L.: 'An Introduction to Neural Networks', XP001152218 Retrieved from HTTP: //WWW.CS.STIR.AC.UK/~LSS/NNINTRO/INVSL IDES.HTML**

Remarks:
The file contains technical information submitted after the application was filed and not included in this specification

EP 1 382 976 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

**Description**

US patent No. 5,684,946 discloses a design verification method wherein an input stimulus is applied to a device under test. The device under test is represented by a design model which can be constructed using specialized programming languages such as Verilog or standard programming languages such as C programming language. The US patent also discloses a "correlation engine" that correlates the output of the device under test with the input stimuli in order to generate input stimuli which will cause the most "interesting events". According to the US patent, such a correlation engine can be based on a "Design Of Experiments" (DOE)-method or other correlation methods such as the use of a neural network. The US patent further mentions that the verification process described therein could also be applied to prototype hardware.

The article "Test Generation Using Neural Computers" (S. T. Chakradhar, V. D. Agrawal, M. L. Bushnell; International Journal of Computer Aided VLSI Design 3, 241-257 (1991)) describes a method wherein a neural network is used to model an integrated circuit. To this end, all circuit elements - such as Boolean gates - are transformed into neural network nodes. Later on, the test generation problem is formulated as an energy minimization problem based on an "energy function".

To achieve high performance and high integration density, the dimensions of integrated circuit components are scaled down more and more. In particular, transistor dimensions are scaled down while lower power dissipation is achieved by scaling down the supply voltage. However, due to high packing density of transistors, the power supply current is increasing, and hence, large current swings within a short period of time can cause considerable noise. As a consequence, one difficulty circuit designers face is the power delivery of very high performance circuits due to the severe switching noise.

In order to verify the function of a newly designed integrated circuit, the circuit is first simulated and then tested. During simulation, multiple input signals are applied to the inputs of the circuit, and the output signals of the circuit calculated. The input signals are referred to as test patterns. If the output signals do not sufficiently approximate preset target signals, the circuit is redesigned and resimulated.

Subsequently, when simulation is completed, a chip containing the integrated circuit is manufactured and tested using ATE (Automatic Test Equipment). The ATE also applies a test pattern to the circuit. The test pattern for the ATE has to be input manually by a user. Generally, the same test pattern that has been used for simulation is also used for testing. If the output signals generated by the circuit in response to the test pattern of the ATE deviate from preset target signals, the circuit is redesigned, resimulated and retested.

As the complexity of integrated circuits increases, integration density and functionality increases dramatically. The simultaneous switching of a large number of transistors induces a large current spike. The switching noise on the power distribution network must be suppressed to a tolerable level to ensure the reliability of the circuit. In order to efficiently combat the switching noise, estimation of the worst case switching noise is required.

On way of determining the worst case switching noise is to simulate all combinations of input patterns to determine which combination will induce the maximum switching noise. However, the complexity of the solution space is exponentially proportional to the number of primary inputs of the system. Accordingly, it would require an enormous time to process the entire solution space for even a moderately complex system.

As a consequence, it is almost impossible to determine all test patterns that cause worst case switching noise by simulation or testing. Accordingly, a small set of test patterns that cause at least some worst case scenarios can be selected. However, this way, the simulation or testing of the integrated circuit may not be satisfactory.

The designer thus has to accept either enormous time requirements for simulation and testing, or potentially insufficient simulation or testing efficiency. This is clearly undesirable.

To this end, some approaches have been proposed to deal with these problems. In "Estimation of Switching Noise on Power Supply Lines in Deep Sub-micron CMOS circuits", Shiyou Zhao and Kaushik Roy, 13th International Conference on VLSI Design, IEEE January 2000, there is proposed a probabalistic approach to determine the lower bound of the worst case switching noise on power supply lines. The algorithm described therein traces the worst case input patterns which induces the steepest maximum switching current spike and therefore the maximum switching noise. This is based on the observation that the maximum switching noise is directly related to the steepest maximum switching current spike.

In this approach, the design of an integrated circuit is simulated by applying randomly generated input signal vectors to the inputs of the circuit. For each input vector pair, the simulated peak switching current is determined. The worst case input vector pairs feed, as initial population, a genetic algorithm. The genetic algorithm is designed to single out the near optimal input pattern(s) that induce the steepest maximum switching current spike and, therefore, the worst case switching noise. The worst case input patterns are then used in HSPICE simulation of the circuits to extract the exact current waveform.

One problem associated with this approach is the difficulty of generating suitable random test patterns. The larger the number of random test patterns, the higher the likelihood of generating a test pattern which approximates the worst case sufficiently. However, since the simulation of each test pattern is time consuming, the simulation of a large number number of test patterns is not practical.

In particular, if a genetic algorithm is used, it is too time consuming to simulate every single random pattern out of every new pattern population before the algorithm is able to determine which of the patterns of the population is to be selected for further optimization. Therefore, this method becomes saturated by the number of trial random patterns in each pattern population. It is suitable for small circuits. However, it could take up to years to perform a full chip simulation of a large circuit using even the fastest simulation applications.

The present invention aims to address these problems.

According to the invention, there is provided a method of testing an integrated circuit according to claim 1, a data processing system according to claim 31 and a computer program according to claim 32. In a "learning mode" of this method, the behaviour of the integrated circuit is approximated, the learning mode comprising:

(a) applying a set of test patterns to the integrated circuit;
(b) applying the set of test patterns to a neural network;
(c) comparing the outputs of the integrated circuit and the outputs of the neural network; and
(d) adapting parameters of the neural network to approximate the behaviour of the integrated circuit on the basis of the comparison.

In particular, the test patterns may be applied to the integrated circuit via an automatic test equipment (ATE). The neural network may be integrated in the ATE. It may be implemented using any known ATE.

The invention is based on the idea that the dynamic behaviour of the integrated circuit device can be learnt from a set of random test patterns using a neural network.

After the learning process has been completed, the ATE is able to perform test pattern classification. The ATE may thus select sub-optimal patterns for subsequent simulation or testing of the integrated circuit. The selected test patterns sufficiently approximate worst case scenarios.

Accordingly, the invention also provides for an operation mode, the operation mode comprising:

(m) applying further test pattern to the neural network whose parameters have been adapted to approximate the behaviour of the integrated circuit as described above;
processing the output of the neural network to determine whether predetermined criteria are met; and
selecting those further test patterns that meet predetermined criteria and
applying the selected test patterns to the integrated circuit in order to test the integrated circuit.

Using this method, a sufficient number of test patterns are provided for an efficient testing of the integrated circuit.

The latter mode of operation of the neural network can be referred to as "operation mode".

Accordingly, there is also provided a method of testing an integrated circuit; the method comprising: applying test patterns that have been selected according to the above described method of selecting test patterns to the integrated circuit using automatic test equipment (ATE).

According to a preferred embodiment of the invention, the test patterns that have been selected in accordance with the above described neural network-based approach are further optimized using a genetic algorithm.

Thus, there is provided a method of providing a test pattern for the simulation and/or test of the layout of an integrated circuit, the method comprising the steps of:

(A) providing a set of test patterns consisting of test patterns selected in accordance with the above described method of selecting test patterns;
(B) applying the set of selected test patterns to the integrated circuit using automatic test equipment (ATE);
(C) determining the outputs of the integrated circuit;
(D) processing the outputs to determine whether predetermined test criteria are met;
(E) depending on the determination in step (D), generating a new set of test patterns on the basis of the set of selected test patterns provided by step (A) using a genetic algorithm.

This combination of neural network- and genetic algorithm-based approaches further increases the chances of finding test patterns that sufficiently approximate worst case scenarios of operation of the integrated circuit.

The method employs a genetic algorithm (optimization method) to optimize a set of pre-selected patterns based on measurements using an ATE. Thereby, a set of worst case noise patterns can be selected automatically. By using ATE for the processing of the test patterns, performance is greatly enhanced compared to approaches based on simulation.

Test patterns generated accordingly can additionally be resimulated for further detail design analysis and improvement.

The genetic algorithm approach can be implemented using existing ATEs.

The invention will now be described, by way of example only, with reference to the accompanying drawings, of which:

Figure 1 illustrates schematically a classification of three groups of test patterns;

Figure 2 illustrates a process representing the neural network learning mode according to an embodiment of the invention;

Figure 3 illustrates a process representing the neural network operation mode according to an embodiment of the invention;

Figure 4 illustrates a schematic flow diagram of a genetic algorithm using intital random pattern generation; and

Figure 5 illustrates a schematic flow diagramm of a method combining neural network-based pre-selection of test patterns and subsequent optimization using a genetic algorithm.

In accordance with one embodiment of the invention, a neural network model is implemented into the ATE. That is, the ATE is able to learn automatically from test runs of an integrated circuit performed on the ATE. After training of the neural network has been completed, it is able to identify which group of test patterns belong to a sub-optimal set. For this purpose, some million test patterns are selected via the neural network. Subsequently, the pre-selected sub-optimal pattern is simulated (simulation approach) or measured (ATE approach) to further determine which of the patterns fulfill predetermined criteria. Those patterns which fulfill the criteria are selected for storage.

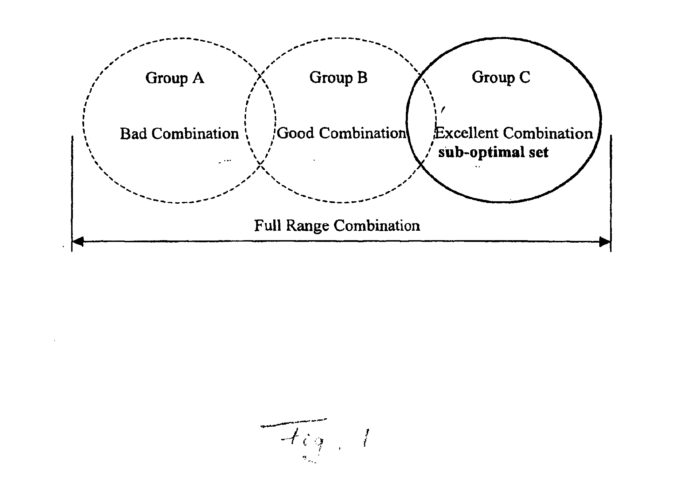

Figure 1 illustrates schematically a classification of three groups of patterns. Since the simulation approach- or ATE approach-based selection of patterns is performed on the basis of a sub-optimal set of patterns (group C), the speed and efficiency compared to conventional methods for identifying suitable test patterns is considerably improved. This approach is referred to as maximum approximation.

Suppose, as illustrated in Figure 1, there are $P_N \in \{P_N^A \ P_N^B \ P_N^C\}$, $N > 0$, three groups of test patterns within a full range of all possible test patterns. Instead of searching through all possible patterns, the neural network may learn and distinguish between different groups of test patterns using an ATE-based training program. Accordingly, the test patterns are pre-classified.

In the maximum approximation algorithm mode, the sub-optimal set $P_N^C$ and $P_N^B \cap P_N^C$ are generated based on neural network decisions, and a sub-optimal pattern set forms a new pattern population.

This process can be repeated iteratively on the basis of the new pattern population, thereby to select the best group of patterns out of the sub-optimal population, and so on.

A neural network is an interconnected assembly of simple processing elements, units or nodes, whose functionality is loosely based on that of the animal neuron. The network ability of the network is stored in the inter-unit connection strenghts, or weights, obtained by a process of adaptation to, or learning from, a set of training patterns.

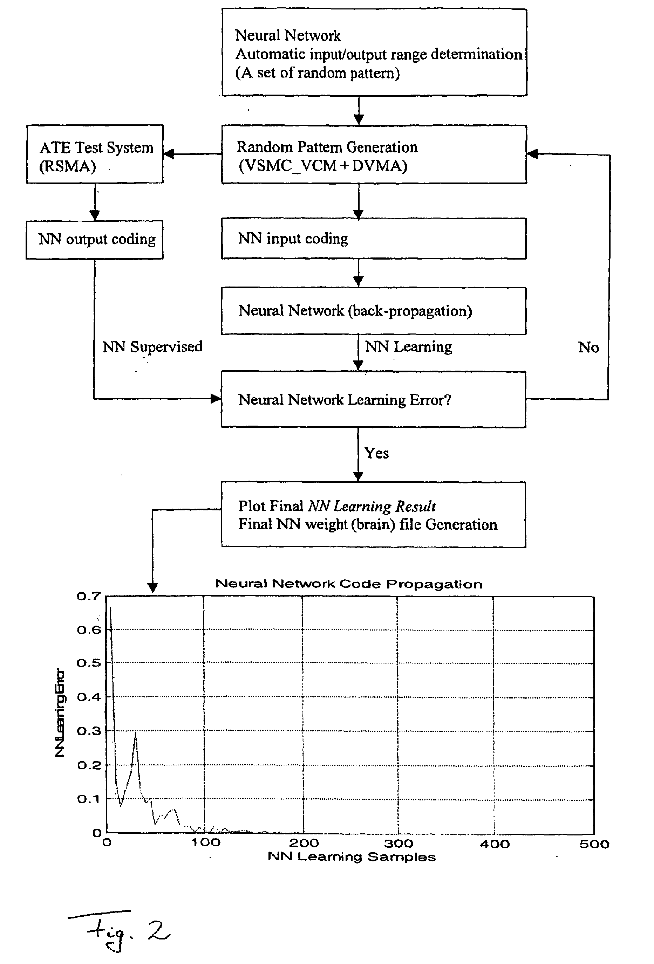

Figure 2 illustrates a process representing the neural network learning mode according to an embodiment of the invention. The neural network is based on back-propagation net characteristics to perform a pattern classification task. In the beginning, the neural network learns from a set of random patterns. The test results are supervised by a test system (ATE). The learning process is terminated when the learning error is less than a predetermined value. Subsequently, a neural network learning weight ("brain") file is generated. This file is then used in operation mode to perform a pattern classification task.

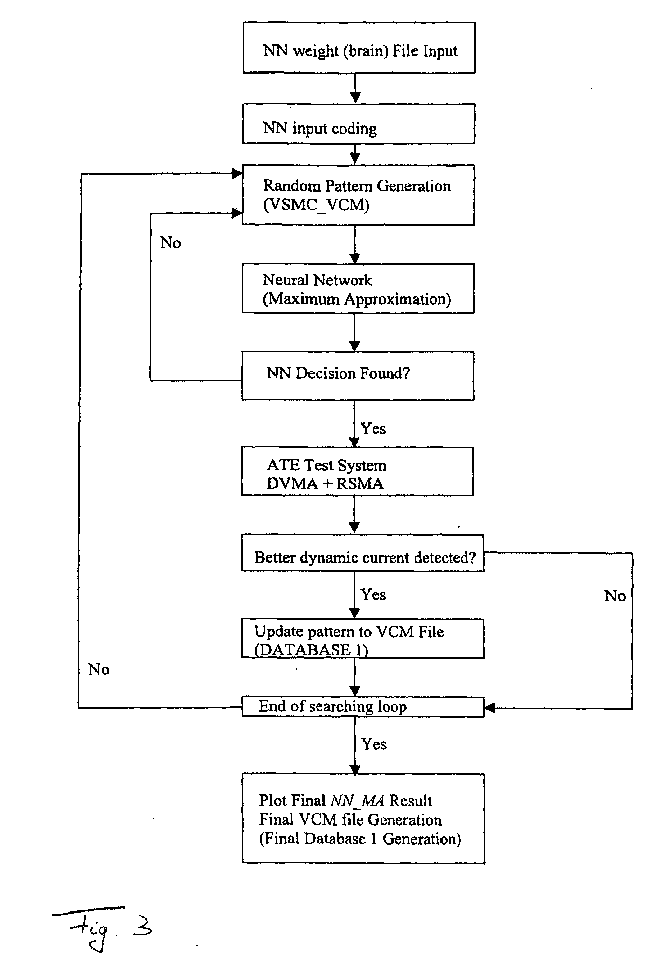

Figure 3 illustrates a process representing the neural network operation mode according to an embodiment of the invention. In the operation mode, the neural network is able to perform pattern classification based on previous learning experience (contained in the NN brain file) for pattern approximation and selection. The procedure of pattern selection may be based on a very small set of NN pattern populations. For example, one NN pattern population may include six NN decision patterns. The neural network first determines whether any pattern out of these six NN decision patterns belong to a potential maximum current group (sub-optimal group). If yes, then this pattern is selected. If no, then the search is repeated using the same procedure. In the final network classification, only those patterns are selected which cause a higher dynamic current than patterns that have been tested in real measurements (RSMA). For example, using this approach, 6*100 = 600 patterns can be classified, of which only 100 patterns require testing through measurement to determine if they cause higher dynamic currents, while the other 500 patterns are classified by the neural network.

An implementation of the neural network pattern learning process and the neural network pattern classification process is given in Annex 1 and Annex 2, respectively.

In one embodiment of the invention, the neural network is a back-propagation neural network. Back-propagation is a supervised learning algorithm mainly used by multi-layer-perceptrons in order to change the weights associated with the net's hidden neuron layer(s).

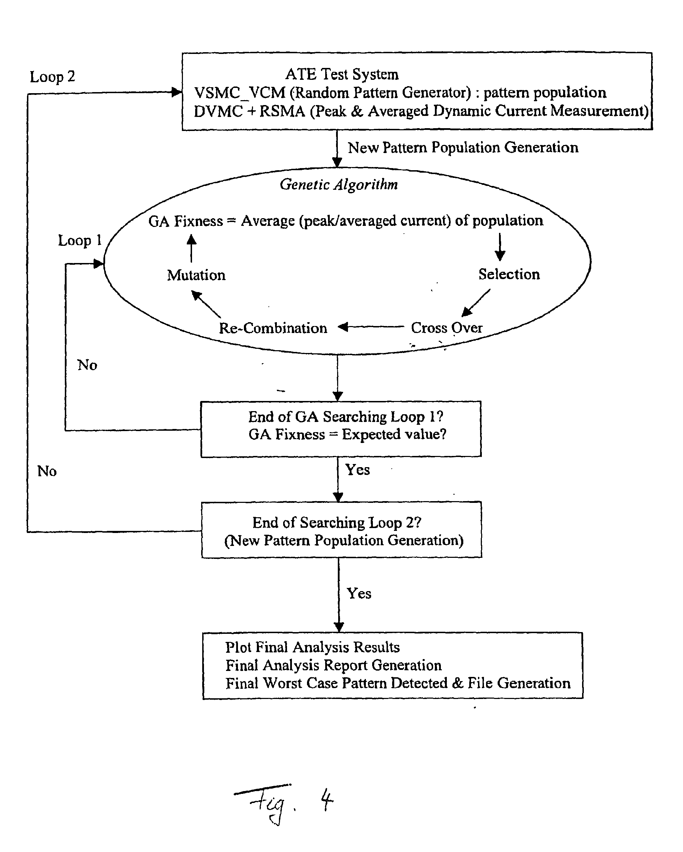

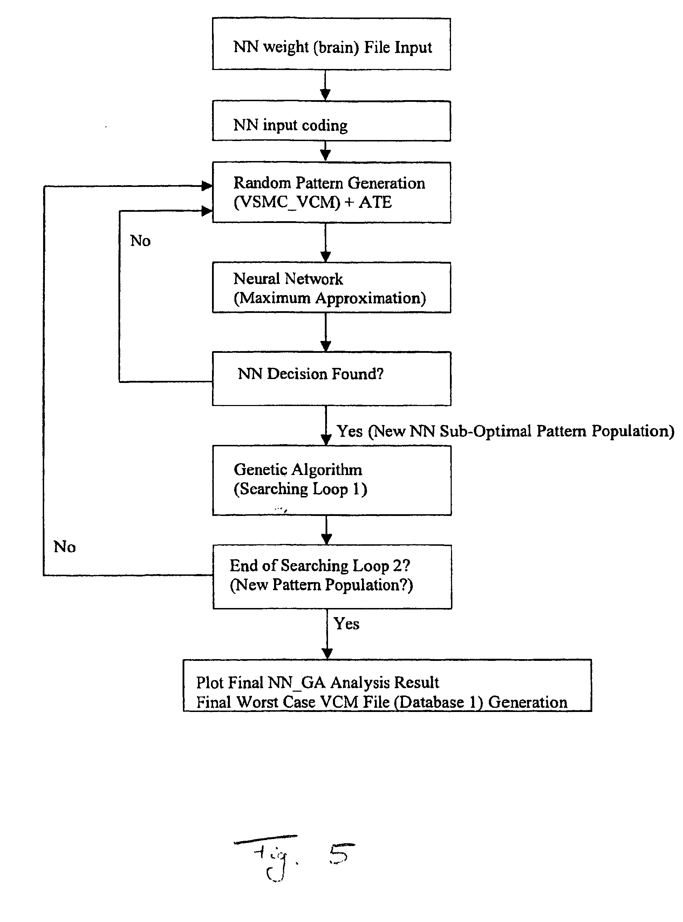

Another embodiment of the invention will now be described by reference to Figures 4 and 5. In this embodiment, test patterns selected by the neural network are further optimized using a genetic algorithm.

For the purposes of illustration, Figure 4 shows a schematic flow diagram of a genetic algorithm without pre-selection of test patterns by a neural network (instead, the initial patterns are generated on a random basis).

Figure 5 illustrates a schematic flow diagramm of a method combining neural network-based pre-selection of test patterns and subsequent optimization using a genetic algorithm, in accordance with an embodiment of the invention.

Genetic algorithms are based on the principles of natural selection. In particular, genetic algorithms are stochastic search methods which simulate natural biological evolution. The algorithms operate on the basis of a population of potential solutions and, applying the principle of "survival of the fittest" to these potential solutions, produce a better approximation of a target solution in each iteration of the algorithm.

Each iteration of the algorithm produces a new generation of approximations. The approximations of each generations are created by the process of selecting individuals according to their level of "fitness" in the problem domain. The selected individuals are bred with one another using operators borrowed from natural genetics. This process leads to the evolution of populations of individuals that are better suited for their environment than the individuals from which they were created, just as in natural adaptation.

Accordingly, genetic algorithms model natural processes such as selection, cross over, recombination and mutation.

Figure 4 shows a method for detecting the worst case current consumption/peak current pattern (RSMA) based on a genetic algorithm. This method operates on the basis of populations of individual patterns instead of a single pattern solution. In this way, the search for better approximations can be performed in a parallel manner. Therefore, this method is more efficient than single pattern searching processes using dynamic random algorithm methods.

Genetic algorithms may be employed for the simulation of an integrated circuit design in order to solve the worst case pattern search problem. The efficiency of genetic searching procedures is largely dependent on the number of pattern populations and the number of test patterns in each pattern population. However, as indicated above, the simulation-based approach forms a limitation if genetic algorithms are to be employed. The genetic selection procedure has to evaluate every "fitness" (dynamic peak/averaged current) of the test patterns in each pattern population. For example, there may be 200 pattern populations each including 20 patterns. Thus, the genetic algorithm has to evaluate the fitness of 200 * 20 = 4000 patterns. If each test pattern is a 50 cycles test pattern which requires 30 minutes of simulation time (e.g. EPIC oder SPICE simulator), then the total required searching and simulation time is 4000 * 30 minutes = 120000 minutes, i.e. approximately 83 days of non stop simulation in order to process 200 pattern populations only.

In addition, the full pattern combination domain increases proportionally to the complexity of VLSI or ULSI designs. Therefore, a subset of 200 pattern populations is only a very small subset of the full pattern combination domain.

In contrast, when using a genetic algorithm together with ATE, many more pattern populations per time unit can be processed. This is because the testing of an integrated circuit using ATE is considerably faster than simulation using conventional systems. Accordingly, the approximation of worst case test patterns in a given period of time is much more accurate.

An implementation of a dynamic genetic algorithm for use with ATE is presented in the following. At the beginning of the computation, a number of individual random patterns

$$P_N{}^{POP} = (p_1, p_2, ..., p_N)$$

are randomly generated and initialized, wherein N is the maximum number of random patterns and POP is the maximum number of pattern populations.

Subsequently, for each individual pattern $(p_1, p_2, ..., p_N)$, the objective functions

$$I_{peak}\left(\forall\ I_{sample}(P_N,\ SRMS)\right)$$

and

$$I_{averaged}(P_N, \; SRMS)$$

are evaluated using equation (1):

$$I_{Measurement}(P_N,T) = \frac{V_{DD}(P_N,T)}{R_{eff}} + \frac{1}{L_{eff}} \int_{T_{min}}^{T_{max}} V_{DD}(P_N,T)dT + \Delta I_{CMOS}(P_N,T), \; \forall T, P_N > 0$$

$$T = SRMS(T_{min},T_{max}) \Rightarrow Random\_Float\_Number(T_{min},T_{max})$$

$$T_{max} \geq T_{min}, \; \forall T_{min}, T_{max} > 0, \; I_{Measurement}(P_N,T) \in \left\{ I_{peak} \quad I_{averaged} \right\}$$

The first (initial) generation is thus produced, and the averaged fitness of the individual patterns ($p_1$, $p_2$, ..., $p_N$) is calculated using equation (2):

$$Averaged\_Fitness(Fitness(P_N^{POP})) = \frac{\sum_{N=0}^{N} I_{Measurement}(P_N)}{N}, \; N, P_N > 0$$

$$Fitness(P_N) = I_{Measurement}(P_N,T) \in \left\{ I_{peak} \quad I_{averaged} \right\}$$

If the optimization criteria

$$(Averaged\_Fitness(I_{Measurement}(P_N^{POP})) \; < \; I_{MAX\_REF})$$

is not met for any existing population, a new population is created on the basis of the existing population. Individual patterns are selected according to their fitness for the production of offspring (loop1 in Figure 4).

In this selection approach, the basic concept of tournament selection is employed. That is, only the best individual pattern from the existing population is selected as a parent. This process is repeated until a pre-defined percentage of best patterns has been selected:

(3)

$$Sorting(I_{Measurement}(P_N) \in \left\{ I_{min}(P_{N_{min}}) \; ..... \; I_{max}(P_{N_{max}}) \right\}) \Rightarrow Parent(I_{Measurement}(P_N))$$

$$N \in \left\{ N_{min} \quad N_{max} \right\} \qquad N \in \left\{ N_{min} = N_{max} - (N_{max} \times B) \quad N_{max} \right\}$$

wherein B is the pre-defined percentage of the best pattern group. The sorting function first re-arranges the test patterns from minimum to maximum according to their fixness values. Subsequently, the parent selection is generated in random sequence based on the new sub-optimal fixness range N, which is calculated using B. Parents (selected patterns) are combined using cross over (4), re-combined (5) and mutated (6) in order to produce offspring:

$$CrossOver(P_N(C_1,C_2),P_{N+1}(C_3,C_4)) \Rightarrow Upper\_CrossOver(P_N(C_3,C_2),P_{N+1}(C_1,C_4))$$

$$\Rightarrow Lower\_CrossOver(P_N(C_1,C_4),P_{N+1}(C_3,C_2)) \quad (4)$$

$$\Rightarrow Stripe\_CrossOver(P_N(C_4,C_3),P_{N+1}(C_2,C_1))$$

where C is the test pattern content which is selected for cross over of two patterns. In the cross over process, upper, lower or stripe cross over methods are performed in random sequence, and the contents of two cross over patterns are exchanged in order to produce two new offspring patterns.

Thereafter, the re-combination equation (5) is used to select the best fixness pattern out of two new cross over offspring patterns:

$$\mathrm{Re}\,combination(P_N, P_{N+1}) \Rightarrow I_{\max imum}(P_N, P_{N+1}) \Rightarrow I_{Best}(P_M), \quad N, M, P_N > 0 \qquad (5)$$

$$Mutation(P_M(C_1, C_2, C_3, C_4....C_y)) \Rightarrow P_M(C_1 + R_1, C_2 + R_2,......C_y + R_y)$$
$$R_y \in \{1 \quad 0 \quad -1\}, \quad M, P_M, y > 0 \qquad (6)$$

where M is the number of new selected offspring patterns to form the new population. After recombination, the offspring undergoes mutation. Offspring variables are mutated by the addition of small random values

$$Ry \in \{1 \quad 0 \quad -1\}.$$

The mutation process helps to improve the optimization search process.

Finally, all offspring patterns are inserted into the population, replacing the parents (original pattern population) and producing a new generation. This cycle (loop 1 in Figure 4) is performed until the optimiziation criteria are met.

If the fitness does not improve after a pre-defined number of genetic breeding generations, a new pattern population (loop 2 in Figure 4) will be generated in random sequence. This combination greatly increases the chances of finding worst case test patterns.

A complete implementation of this algorithm using ATE J973 is given in Annex 3.

Figure 5 illustrates a flow diagramm of a method combining neural network-based pre-selection of test patterns and subsequent optimization using a genetic algorithm.

A complete implementation of this combined approch using ATE J973 is given in Annex 4.

It is to be noted that the invention is not restricted to the embodiments and implementations described herein but encompasses modifications and variations within the scope of the invention as determined from the claims.

**Annex 1**: Neural Network Pattern Learning Implementation Using ATE J973

*Start Neural Network Training Using ATE:* Circuit Initialization

Default AC/DC Specification Initialization.

*DP* Dummy Pattern : Vector Memory Initialization

*INPUT: {N Vector_cycle DP Auto_Range $\varepsilon$ G Epoch Max_Loop EX File_Name}*

Check if Input valid?

else Input Error! exit(1).

For *P1* = 0, 1, 2, 3, .........., *Auto_Range*+1 do : **(Automatic Input & Output Range Calculation)**

$$\{$$

$$Random\_Pattern\_Generation \Rightarrow P \in (p_1, p_2, ...., p_N) : \text{Random Pattern Population}$$

$$\forall vector\_cycle, N > 0$$

$$X(P_N, I_{peak\,/\,averaged}(P_N)) \in \{X_1 \quad X_2 \quad ........ \quad X_i\}, \quad X_{offset} = (C_{max} - C_{min}) \times R_{offset}, \quad R_{offset}, i > 0$$

$$X_1 \in \{X_{min} = X_{min} + X_{offset}\}$$

$$X_2 \in \{X_{mid11} = X_{min} - 1 \quad X_{mid12} = X_{min} + X_{offset}\}$$

$$X_3 \in \{X_{mid21} = X_{mid12} - 1 \quad X_{mid22} = X_{mid21} + X_{offset}\}$$

$$X_4 \in \{X_{max} = X_{mid22} - 1\}$$

$$\}$$

**Neural Network Training Loop:**

$$\{$$

$$Random\_Pattern\_Generation \Rightarrow P \in (p_1, p_2, ...., p_N) : \text{Random Pattern Population}$$

$$\forall vector\_cycle, N > 0$$

$$Vector\_Code\_Matrix(P_N(Vector\_Cycles)) \Rightarrow \begin{bmatrix} P_0(Vector\_Cycles) \\ P_1(Vector\_Cycles) \\ \vdots \\ P_N(Vector\_Cycles) \end{bmatrix}$$

$$P_N(Vector\_Cycles) \in P_N(vector\_encode(\forall signal\_bus), Vector\_Cycles)) \, \textbf{(ATE Training Set)}$$

$$Pattern\_Generator(Vector\_Memory(P_N))$$

$$\Rightarrow Pattern\_Controller(Vector\_Memory(P_N)) \quad N > 0 \; \textit{(Pattern Executor)}$$

Start Pattern Generator: $P_N(T_{min}, T_{max}) \Rightarrow Dynamic\_Pattern$

Start Current Measurement & Calculation:

$$I_{Measurement}(P_N,T) = \frac{V_{DD}(P_N,T)}{R_{eff}} + \frac{1}{L_{eff}}\int_{T_{min}}^{T_{max}} V_{DD}(P_N,T)dT + \Delta I_{CMOS}(P_N,T)\,,\ \forall T, P_N > 0$$

$$T = SRMS(T_{min},T_{max}) \Rightarrow Random\_Float\_Number(T_{min},T_{max})$$

$$T_{max} \geq T_{min}\,,\ \forall T_{min},T_{max} > 0$$

Stop Pattern Generator: $P_N : I_{peak}(\forall I_{sample}(P_N,SRMS))$, $I_{averaged}(P_N,SRMS)$

$$Z^k = I_{Measurement}(P_N,T) \in \{I_{peak}\quad I_{averaged}\}$$

$$X^k(P_N, I_{Measurement}(P_N)) \in \{X_1^k\quad X_2^k\quad ........\quad X_i^k\}\ \textbf{(Neural Network Learning Set)}$$

$$X_j = \sum_i W_{ji} a_i$$

$$Y(X) = \frac{1}{1 + e^{-X \times G}}$$

$$E = \frac{1}{2}\sum_{k=1}^{s}\sum_{j=1}^{n}(Y_j^k - Z_j^k)^2\ \textbf{(Supervising learning via ATE)}$$

$$\frac{\partial E}{\partial w_{ji}} = \sum_k (Y_j^k - Z_j^k) \times Y_j^k(1 - Y_j^k) \times X_i^k$$

$$w_{ji} = w_{ji} - \varepsilon \times (\frac{\partial E}{\partial w_{ij}}) \times G$$

$$E(P_N)+ = E(P_N)\ \text{(pattern population Learning Error calculation)}$$
$$Training\_Loop + +$$

$$if\,(Tranining\_Loop > Epoch)\ \text{(pattern population learning done)}$$
$$\{\ E = \frac{\sum E(P_N)}{Epoch}\ \}$$

$$if\,(Tranining\_Loop > Max\_Loop)$$
{   So Far Neural Network Learning File (*File_Name*) Generation, exit(1) }

$$if\,(E > EX)$$
{   Go To **Neural Network Training Loop : Learn Again!!**  Initialize: $E = 0$  }
else
{   Expected Neural Network Learning File (*File_Name*) Generation, exit(1) }

} **End Of Neural Network Learning**

Final Neural Network Learning Plot Generation (Figure 27).
***End Of Neural Network Learning via ATE***

**Annex 2**: Neural Network Pattern Classification Implementation Using ATE J973

***Start NN_MA:*** Circuit Initialization
Default AC/DC Specification Initialization.

*DP* Dummy Pattern : Vector Memory Initialization

*INPUT: {N Vector_cycle DP Max_Loop File_Name}*

Check if Input valid?

else Input Error! exit(1).

*NN_Learning_File(File_Name)*$\in \{w_{ij}\ \varepsilon\ G\ X^k\}$

**NN_MA_Loop:**

{

*Random_Pattern_Generation* $\Rightarrow P \in (p_1, p_2, ...., p_N)$ : Random Pattern Population

$$\forall vector\_cycle, N > 0$$

$$X^k(P_N, I_{Measurement}(P_N)) \in \left\{ X_1^k \quad X_2^k \quad ........ \quad X_i^k \right\} \text{ (Neural Network Evaluation Set)}$$

$$X_j = \sum_i W_{ji} a_i$$

$$Y_N(X) = \frac{1}{1 + e^{-X \times G}}$$

$$if\ (\forall Y_N(X) < Y_{sub\_optimal\_set})$$

{ Go to **NN_MA_Loop : New Pattern Population Generation !!!** }

else

{ *Sorting*$(P_N, Y_N(X)) \Rightarrow P_M$ (sub-optimal set based on **neural network**) }

$$Vector\_Code\_Matrix(P_M(Vector\_Cycles)) \Rightarrow \begin{bmatrix} P_0(Vector\_Cycles) \\ P_1(Vector\_Cycles) \\ \vdots \\ P_M(Vector\_Cycles) \end{bmatrix}$$

$$P_M(Vector\_Cycles) \in P_M(vector\_encode(\forall signal\_bus), Vector\_Cycles))$$

*Pattern_Generator*(*Vector_Memory*$(P_M)$)

$\Rightarrow$ *Pattern_Controller*(*Vector_Memory*$(P_M)$) $M > 0$ *(Pattern Executor)*

Start Pattern Generator: $P_M(T_{min}, T_{max}) \Rightarrow Dynamic\_Pattern$

Start Current Measurement & Calculation:

$$I_{Measurement}(P_M, T) = \frac{V_{DD}(P_M, T)}{R_{eff}} + \frac{1}{L_{eff}} \int_{T_{min}}^{T_{max}} V_{DD}(P_M, T) dT + \Delta I_{CMOS}(P_M, T), \quad \forall T, P_M > 0$$

$$T = SRMS(T_{min}, T_{max}) \Rightarrow Random\_Float\_Number(T_{min}, T_{max})$$

$$T_{max} \geq T_{min}, \quad \forall T_{min}, T_{max} > 0$$

Stop Pattern Generator: $P_M : I_{peak}(\forall I_{sample}(P_M, SRMS)), I_{averaged}(P_M, SRMS)$

$$I_{Measurement}(P_M, T) \in \{I_{peak} \quad I_{averaged}\}$$

$NN\_Max\_Loop ++$ (operating loop counter)

$Sorting(P_M, I_{Measurement}(P_M)) \Rightarrow P_{selected}$ (best out of sub-optimal set via **ATE**)

$if (I_{Measurement}(P_{selected}) > \forall I_{Measurement}(P_{previous\_selected}))$
  { Update VCM Database File }

$if (NN\_Max\_Loop < Max\_Loop)$
  { Go to **NN_MA_Loop** : **New Pattern Population Generation !!!** }
  else
  { Final VCM Database File Generation exit(1) }

}

Final Neural Network Maximum Approximation Plot Generation (Figure 29).
*End Of NN_MA*

**Annex 3:** Dynamic Genetic Algorithm Implementation Using ATE J973

*Start D_GA:* Circuit Initialization
Default AC/DC Specification Initialization.
*DP* Dummy Pattern : Vector Memory Initialization
*INPUT:* {*N Vector_Cycles DP Loop*1 *Loop*2 $I_{Max\_REF}$}
Check if Input valid?
else Input Error! exit(1).
For *POP* = 0, 1, 2, 3, ....., *Loop*2+1 do :

$$\{$$

$$Random\_Pattern\_Generation \Rightarrow P \in (p_1, p_2, \dots, p_N)$$

$$\forall vector\_cycle, N > 0$$

$$P_N^{POP} = (p_1, p_2, \dots, p_N) \text{ Initial Pattern Population}$$

For P1 = 0, 1, 2, 3, ………., $N+1$ do :

$$\{$$

$$Vector\_Code\_Matrix(P_N(Vector\_Cycles)) \Rightarrow \begin{bmatrix} P_0(Vector\_Cycles) \\ P_1(Vector\_Cycles) \\ \vdots \\ P_N(Vector\_Cycles) \end{bmatrix}$$

$$P_N(Vector\_Cycles) \in P_N(vector\_encode(\forall signal\_bus), Vector\_Cycles))$$

$$Pattern\_Generator(Vector\_Memory(P_N))$$

$$\Rightarrow Pattern\_Controller(Vector\_Memory(P_N)) \quad N > 0 \quad (Pattern\ Executor)$$

Start Pattern Generator: $P_N(T_{min}, T_{max}) \Rightarrow Dynamic\_Pattern$

Start Current Measurement & Calculation:

$$I_{Measurement}(P_N, T) = \frac{V_{DD}(P_N, T)}{R_{eff}} + \frac{1}{L_{eff}} \int_{T_{min}}^{T_{max}} V_{DD}(P_N, T)dT + \Delta I_{CMOS}(P_N, T), \ \forall T, P_N > 0$$

$$T = SRMS(T_{min}, T_{max}) \Rightarrow Random\_Float\_Number(T_{min}, T_{max})$$

$$T_{max} \geq T_{min}, \ \forall T_{min}, T_{max} > 0$$

Stop Pattern Generator: $P_N : I_{peak}(\forall I_{sample}(P_N, SRMS)), I_{averaged}(P_N, SRMS)$

$$Fitness(P_N) = I_{Measurement}(P_N, T) \in \{I_{peak} \quad I_{averaged}\}$$

$$\}$$

$$Averaged\_Fitness(Fitness(P_N^{POP})) = \frac{\sum_{N=0}^{N} I_{Measurement}(P_N)}{N}, \ N, P_N > 0$$

if (Averaged_ Fitness($I_{Measurement}(P_N^{POP})$)) > $I_{Max\_REF}$)

{ Final VCM Generation (Database I) exit(1) }

For P2 = 0, 1, 2, 3, ………, Loop1+1 do :

$$\{$$
$$Sorting(I_{Measurement}(P_N) \in \{I_{\min}(P_{N_{\min}}) \quad ..... \quad I_{\max}(P_{N_{\max}})\}) \Rightarrow Parent(I_{Measurement}(P_N))$$
$$N \in \{N_{\min} \quad N_{\max}\} \qquad\qquad N \in \{N_{\min} = N_{\max} - (N_{\max} \times B) \quad N_{\max}\}$$

$$CrossOver(P_N(C_1,C_2),P_{N+1}(C_3,C_4)) \Rightarrow Upper\_CrossOver(P_N(C_3,C_2),P_{N+1}(C_1,C_4))$$
$$\Rightarrow Lower\_CrossOver(P_N(C_1,C_4),P_{N+1}(C_3,C_2))$$
$$\Rightarrow Stripe\_CrossOver(P_N(C_4,C_3),P_{N+1}(C_2,C_1))$$

$$\mathrm{Re}combination(P_N,P_{N+1}) \Rightarrow I_{\max imum}(P_N,P_{N+1}) \Rightarrow I_{Best}(P_M), \quad N,M,P_N > 0$$

$$Mutation(P_M(C_1,C_2,C_3,C_4....C_y)) \Rightarrow P_M(C_1 + R_1, C_2 + R_2, ...... C_y + R_y)$$
$$R_y \in \{1 \quad 0 \quad -1\}, M, P_M, y > 0$$

For P3 = 0, 1, 2, 3, ............, $M$+1 do :
$$\{$$
$$Pattern\_Generator(Vector\_Memory(P_M))$$
$$\Rightarrow Pattern\_Controller(Vector\_Memory(P_M)) \quad M > 0 \text{ (Pattern Executor)}$$

Start Pattern Generator: $P_M(T_{\min}, T_{\max}) \Rightarrow Dynamic\_Pattern$
Start Current Measurement & Calculation:

$$I_{Measurement}(P_M,T) = \frac{V_{DD}(P_M,T)}{R_{eff}} + \frac{1}{L_{eff}} \int_{T_{\min}}^{T_{\max}} V_{DD}(P_M,T)dT + \Delta I_{CMOS}(P_M,T), \quad \forall T, P_M > 0$$
$$T = SRMS(T_{\min}, T_{\max}) \Rightarrow Random\_Float\_Number(T_{\min}, T_{\max})$$
$$T_{\max} \geq T_{\min}, \quad \forall T_{\min}, T_{\max} > 0$$

Stop Pattern Generator: $P_M : I_{peak}(\forall I_{sample}(P_M, SRMS)), I_{averaged}(P_M, SRMS)$
$$Fitness(P_M) = I_{Measurement}(P_M, T) \in \{I_{peak} \quad I_{averaged}\}$$

$$\}$$

$$Averaged\_Fitness(Fitness(P_M^{POP})) = \frac{\sum_{M=0}^{M} I_{Measurement}(P_M)}{M}, M, P_M > 0$$
$$if(Averaged\_Fitness(I_{Measurement}(P_M^{POP})) > I_{Max\_REF})$$
$$\{ \text{ Worst Case Pattern Found : Final VCM Generation (Database 1) exit(1) } \}$$

$$\} \; End \; Of \; Loop \; 1$$
$$\} \; End \; of \; Loop \; 2$$

*Update So Far Worst Case Pattern Found : Final VCM Generation (Database 1)*
**End Of D_GA**

**Annex 4**: Combined Neural Network Pattern Classification and Dynamic Genetic Algorithm Implementation Using ATE J973

**Start NN GA:** Circuit Initialization
Default AC/DC Specification Initialization.
*DP* Dummy Pattern : Vector Memory Initialization
*INPUT: {N Vector_cycle DP Max_Loop Loop1 $I_{Max\_REF}$ File_Name}*
Check if Input valid?
else Input Error! exit(1).

*NN_Learning_File(File_Name)*∈{*w$_{ij}$* ε *G X$^k$*}

**NN_GA_Loop:**

{

$$Random\_Pattern\_Generation \Rightarrow P \in (p_1, p_2, ...., p_N) : \text{Random Pattern Population}$$
$$\forall vector\_cycle, N > 0$$

$$X^k(P_N, I_{Measurement}(P_N)) \in \{X_1^k \quad X_2^k \quad ........ \quad X_i^k\} \text{ (\textbf{Neural Network Evaluation Set})}$$

$$X_j = \sum_i W_{ji} a_i$$

$$Y_N(X) = \frac{1}{1 + e^{-X \times G}}$$

$$if (\forall Y_N(X) < Y_{sub\_optimal\_set})$$
{ Go to **NN_MA_Loop** : New Pattern Population Generation !!! }
else
{ $Sorting(P_N, Y_N(X)) \Rightarrow P_M$ (sub-optimal set based on **neural network**) }

$$P_M \Rightarrow P_N \text{ (replacing the old population with new sub-optimal set)}$$

For P1 = 0, 1, 2, 3, .........., *Loop1*+1 do : (Start **genetic algorithm** to further improve sub-optimal set)
{

$$Sorting(I_{Measurement}(P_N) \in \{I_{min}(P_{N_{min}}) \quad ..... \quad I_{max}(P_{N_{max}})\}) \Rightarrow Parent(I_{Measurement}(P_N))$$
$$N \in \{N_{min} \quad N_{max}\} \qquad\qquad N \in \{N_{min} = N_{max} - (N_{max} \times B) \quad N_{max}\}$$

$$CrossOver(P_N(C_1,C_2),P_{N+1}(C_3,C_4)) \Rightarrow Upper\_CrossOver(P_N(C_3,C_2),P_{N+1}(C_1,C_4))$$
$$\Rightarrow Lower\_CrossOver(P_N(C_1,C_4),P_{N+1}(C_3,C_2))$$
$$\Rightarrow Stripe\_CrossOver(P_N(C_4,C_3),P_{N+1}(C_2,C_1))$$

$$\mathrm{Re}\,combination(P_N,P_{N+1}) \Rightarrow I_{\max imum}(P_N,P_{N+1}) \Rightarrow I_{Best}(P_M), \quad N,M,P_N > 0$$

$$Mutation(P_M(C_1,C_2,C_3,C_4....C_y)) \Rightarrow P_M(C_1+R_1,C_2+R_2,......C_y+R_y)$$
$$R_y \in \{1 \quad 0 \quad -1\}, \quad M,P_M,y > 0$$

For  P3 = 0, 1, 2, 3, .........., M+1 do :
{

*Pattern _ Generator(Vector _ Memory($P_M$))*

$\Rightarrow$ *Pattern _ Controller(Vector _ Memory($P_M$))*  M > 0  *(Pattern Executor)*

Start Pattern Generator:  $P_M(T_{\min},T_{\max}) \Rightarrow$ *Dynamic _ Pattern*
Start Current Measurement & Calculation:

$$I_{Measurement}(P_M,T) = \frac{V_{DD}(P_M,T)}{R_{eff}} + \frac{1}{L_{eff}}\int_{T_{\min}}^{T_{\max}} V_{DD}(P_M,T)dT + \Delta I_{CMOS}(P_M,T), \quad \forall T,P_M > 0$$

$$T = SRMS(T_{\min},T_{\max}) \Rightarrow Random\_Float\_Number(T_{\min},T_{\max})$$
$$T_{\max} \geq T_{\min}, \quad \forall T_{\min},T_{\max} > 0$$

Stop Pattern Generator:  $P_M : I_{peak}(\forall I_{sample}(P_M,SRMS)), I_{averaged}(P_M,SRMS)$
$$Fitness(P_M) = I_{Measurement}(P_M,T) \in \{I_{peak} \quad I_{averaged}\}$$
}

$$Averaged\_Fitness(Fitness(P_M^{POP})) = \frac{\sum_{M=0}^{M} I_{Measurement}(P_M)}{M}, M,P_M > 0$$

$if(Averaged\_Fitness(I_{Measurement}(P_M^{POP})) > I_{Max\_REF})$
    { *Worst Case Pattern Found : Final VCM Generation (Database 1)  exit(1) }*

} *End Of Loop 1*

*NN _ Max _ Loop + +*   (operating loop counter)

*if ( NN _ Max _ Loop < Max _ Loop )*
    { Go to **NN_GA_Loop : New Pattern Population Generation !!!** }
else
    { *So Far Worst Case Pattern Found : Final VCM Generation (Database 1)  exit(1) }*

}

Final Neural Network + GA Plot Generation (Figure 31).
*End Of NN _ GA*

## Claims

**1.** A method of testing an integrated circuit; the method comprising:

- adapting a neural network to approximate the behaviour of the integrated circuit wherein

    (a) a set of test patterns is applied to the integrated circuit;
    (b) the set of test patterns is also applied to the neural network;
    (c) the outputs of the integrated circuit and the outputs of the neural network are compared; and
    (d) parameters of the neural network are adapted to approximate the behaviour of the integrated circuit on the basis of the comparison;

- (m) thereafter, applying further test patterns to the adapted neural network;
- (n) processing the output of the neural network to determine whether predetermined criteria are met;
- selecting those further test patterns that meet the predetermined criteria;
- (A) providing a set of test patterns consisting of the selected test patterns;
- (B) applying the set of selected test patterns to the integrated circuit using automatic test equipment (ATE);
- (C) determining the outputs of the integrated circuit;
- (D) processing the outputs to determine whether predetermined test criteria are met; and
- (E) depending on the determination in step (D), generating a new set of test patterns on the basis of the set of selected test patterns provided by step (A) using a genetic algorithm.

**2.** The method of claim 1, wherein the set of test patterns and/or the selected test patterns are applied to the integrated circuit via an automatic test equipment.

**3.** The method of claim 2, wherein the neural network is implemented in the automatic test equipment.

**4.** The method of claim 1 or 2, wherein the set of test patterns is generated on a random basis.

**5.** The method of any preceding claim, wherein step (d) comprises:

adapting inter-unit weights of the neural network through back-propagation.

**6.** The method of any preceding claim, comprising:

repeating steps (a) to (d) until a level of adaptation in step (d) falls below a predetermined value.

**7.** The method of claim 6, comprising:

storing data representing predetermined neural network parameters following termination of the repetition of steps (a) to (d).

**8.** The method of any preceding claim, comprising: (o) selecting for storage the selected test pattern if the predetermined criteria are met.

**9.** The method of claim 8, comprising:

repeating steps (m) to (o) until a predetermined number of selected test patterns have been stored.

**10.** The method of claim 8 or 9, wherein the predetermined criteria are met if a value of a predetermined parameter of a signal output by the neural network in response to the application of the selected test pattern exceeds a reference value.

**11.** The method of claim 10, comprising:

(p) applying a further set of selected test patterns to the integrated circuit using automatic test equipment (ATE);
(q) measuring the values of the predetermined parameter of output signals generated by the integrated circuit in response to step (p), wherein the predetermined criteria are met if the value of the predetermined parameter of the signal output by the neural network in response to the application of the selected test pattern exceeds the reference value and all values measured in this step (q).

**12.** The method of claim 11, wherein the further set of test patterns is generated on a random basis.

13. The method of any of claims 10 to 12, wherein the predetermined parameter is a current.

14. The method of any of claims 8 to 13, further comprising:

(r) generating a test pattern population consisting of a plurality of test patterns;
(s) applying each test pattern of the test pattern population to the neural network;
(t) for each test pattern, processing the output of the neural network to determine a value of a predetermined parameter;
(u) allocating each test pattern to one of a plurality of classification groups in accordance with the value of the predetermined parameter determined in step (t).

15. The method of claim 14, comprising:

repeating steps (r) to (u) using a new test pattern population consisting of the test patterns included in a selected one of the classification groups.

16. The method of claim 15, wherein the selected one of the classification groups consists of test patterns that approximate a set of worst case input parameters of operation of the integrated circuit.

17. The method of any of claims 8 to 16, comprising:

repeating steps (m) to (o) plural times;
applying the test patterns selected in each step (o) to the integrated circuit using automatic test equipment (ATE); processing the output of the automatic test equipment to determine whether further predetermined criteria are met; and
selecting for storage those test patterns which meet the further predetermined criteria.

18. The method of any preceding claims, wherein the predetermined criteria represent an approximation of a worst case mode of operation of the integrated circuit.

19. The method of any of the preceding claims, comprising: (F1) repeating steps (B) to (E) until the predetermined test criteria are met.

20. The method of any of the preceding claims, comprising: (F2) repeating steps (B) to (E) for a predetermined number of times or until the predetermined test criteria are met.

21. The method of any of the preceding claims, wherein the predetermined test criteria are met if the set of selected test patterns is associated with an average fitness above a predetermined value.

22. The method of any of the preceding claims, wherein step (E) comprises:

combining some or all of the selected test patterns according to the genetic algorithm to provide the new set of test patterns.

23. The method of claim 22, further comprising;

selecting test patterns out of the set of selected test patterns according to predetermined selection criteria; and combining the selected test patterns according to the genetic algorithm to provide the new set of test patterns.

24. The method of claim 23, comprising:

selecting a test pattern if it is associated with a fitness value greater than a reference value.

25. The method of claim 23 or 24, comprising:

(G) selecting a test pattern if it is associated with a highest fitness value of all unselected test patterns.

26. The method of claim 25, comprising:

repeating step (G) until a predetermined percentage of test patterns has been selected.

27. The method of claim 25, wherein step (E) comprises:

(H) arranging the selected test patterns in the order of associated fitness values;
(I) randomly selecting parent test patterns out of the test patterns as arranged in step (H); and
(J) combining the selected parent test patterns.

28. The method of any of the preceding claims, wherein the genetic algorithm includes crossing over, re-combination, and/or mutation of selected test patterns.

29. The method of any of the preceding claims, wherein step (A) comprises:

providing a plurality of sets of selected test patterns, wherein each set of selected test patterns is included in a test pattern population.

30. The method of claim 29, comprising:

performing the steps of any of the claims for each population.

31. Data processing system, comprising means to perform the method of any preceding claim.

32. Computer program, comprising means for performing the method of any of claims 1 to 30 on a data processing system, when running the system.

**Patentansprüche**

1. Verfahren zum Testen einer integrierten Schaltung, wobei das Verfahren folgendes umfaßt:

- Adaptieren eines neuronalen Netzes zum Approximieren des Verhaltens der integrierten Schaltung, wobei

a) ein Satz Testmuster auf die integrierte Schaltung angewendet wird;
b) der Satz Testmuster auch auf das neuronale Netz angewendet wird;
c) die Ausgaben der integrierten Schaltung und die Ausgaben des neuronalen Netzes verglichen werden und
d) Parameter des neuronalen Netzes adaptiert werden zum Approximieren des Verhaltens der integrierten Schaltung auf der Basis des Vergleichs;

- (m) danach Anwenden weiterer Testmuster auf das adaptierte neuronale Netz;
- (n) Verarbeiten der Ausgabe des neuronalen Netzes zum Bestimmen, ob vorbestimmte Kriterien erfüllt sind;
- Auswählen jener weiterer Testmuster, die die vorbestimmten Kriterien erfüllen;
- (A) Bereitstellen eines Satzes Testmuster, die aus den ausgewählten Testmustern bestehen;
- (B) Anwenden des Satzes ausgewählter Testmuster auf die integrierte Schaltung unter Verwendung von automatischem Testgerät (ATE - Automatic Test Equipment);
- (C) Bestimmen der Ausgaben der integrierten Schaltung;
- (D) Bearbeiten der Ausgaben zum Bestimmen, ob vorbestimmte Testkriterien erfüllt sind; und
- (E) in Abhängigkeit von der Bestimmung in Schritt (D) Erzeugen eines neuen Satzes Testmuster auf der Basis des von Schritt (A) bereitgestellten Satzes ausgewählter Testmuster unter Verwendung eines genetischen Algorithmus.

2. Verfahren nach Anspruch 1, wobei der Satz Testmuster und/oder die ausgewählten Testmuster auf die integrierte Schaltung über ein automatisches Testgerät angewendet werden.

3. Verfahren nach Anspruch 2, wobei das neuronale Netz in dem automatischen Testgerät implementiert wird.

4. Verfahren nach Anspruch 1 oder 2, wobei der Satz Testmuster auf einer Zufallsbasis erzeugt wird.

5. Verfahren nach einem der vorhergehenden Ansprüche, wobei Schritt (d) folgendes umfaßt:

Adaptieren von Zwischen-Einheit-Gewichten des neuronalen Netzes durch Rückausbreitung.

6. Verfahren nach einem der vorhergehenden Ansprüche, umfassend:

Wiederholen der Schritte (a) bis (d), bis ein Adaptationspegel im Schritt (d) unter einen vorbestimmten Wert fällt.

7. Verfahren nach Anspruch 6, umfassend:

Speichern vorbestimmte Parameter des neuronalen Netzes darstellender Daten nach dem Ende der Wiederholung der Schritte (a) bis (d).

8. Verfahren nach einem der vorhergehenden Ansprüche, umfassend:

(o) Auswählen des ausgewählten Testmusters zur Speicherung, falls die vorbestimmten Kriterien erfüllt sind.

9. Verfahren nach Anspruch 8, umfassend:

Wiederholen der Schritte (m) bis (o), bis eine vorbestimmte Anzahl ausgewählter Testmuster gespeichert worden ist.

10. Verfahren nach Anspruch 8 oder 9, wobei die vorbestimmten Kriterien erfüllt sind, wenn ein Wert eines vorbestimmten Parameters eines von dem neuronalen Netz als Reaktion auf das Anwenden des ausgewählten Testmusters ausgegebenen Signals einen Referenzwert übersteigt.

11. Verfahren nach Anspruch 10, umfassend:

(p) Anwenden eines weiteren Satzes ausgewählter Testmuster auf die integrierte Schaltung unter Verwendung eines automatischen Testgeräts (ATE);
(q) Messen der Werte des vorbestimmten Parameters von von der integrierten Schaltung als Reaktion auf Schritt (p) erzeugten Ausgangssignalen, wobei die vorbestimmten Kriterien erfüllt sind, wenn der Wert des vorbestimmten Parameters des von dem neuronalen Netz als Reaktion auf das Anwenden des ausgewählten Testmusters ausgegebenen Signals den Referenzwert und alle in diesem Schritt (q) gemessenen Werte übersteigt.

12. Verfahren nach Anspruch 11, wobei der weitere Satz Testmuster auf einer Zufallsbasis erzeugt wird.

13. Verfahren nach einem der Ansprüche 10 bis 12, wobei der vorbestimmte Parameter ein Strom ist.

14. Verfahren nach einem der Ansprüche 8 bis 13, weiterhin umfassend:

(r) Erzeugen einer Testmusterpopulation, die aus mehreren Testmustern besteht;
(s) Anwenden jedes Testmusters der Testmusterpopulation auf das neuronale Netz;
(t) für jedes Testmuster Verarbeiten der Ausgabe des neuronalen Netzes zum Bestimmen eines Werts eines vorbestimmten Parameters;
(u) Zuordnen jedes Testmusters zu einer von mehreren Klassifikationsgruppen gemäß dem Wert des in Schritt (t) bestimmten vorbestimmten Parameters.

15. Verfahren nach Anspruch 14, umfassend:

Wiederholen der Schritte (r) bis (u) unter Verwendung einer neuen Testmusterpopulation, die aus den Testmustern besteht, die in einer ausgewählten der Klassifikationsgruppen enthalten sind.

16. Verfahren nach Anspruch 15, wobei die ausgewählte der Klassifikationsgruppen aus Testmustern besteht, die einen Satz von Worst-Case-Arbeitseingangsparametern der integrierten Schaltung approximiert.

17. Verfahren nach einem der Ansprüche 8 bis 16, umfassend:

mehrfaches Wiederholen der Schritte (m) bis (o);

Anwenden der in jedem Schritt (o) ausgewählten Testmuster auf die integrierte Schaltung unter Verwendung eines automatischen Testgeräts (ATE);

Verarbeiten der Ausgabe des automatischen Testgeräts zum Bestimmen, ob weitere vorbestimmte Kriterien erfüllt sind; und

Auswählen jener Testmuster zur Speicherung, die die weiteren vorbestimmten Kriterien erfüllen.

18. Verfahren nach einem der vorhergehenden Ansprüche, wobei die vorbestimmten Kriterien eine Approximation eines Worst-Case-Arbeitsmodus der integrierten Schaltung darstellen.

19. Verfahren nach einem der vorhergehenden Ansprüche, umfassend:

(F1) Wiederholen der Schritte (B) bis (E), bis die vorbestimmten Testkriterien erfüllt sind.

20. Verfahren nach einem der vorhergehenden Ansprüche, umfassend:

(F2) Wiederholen der Schritte (B) bis (E) mit einer vorbestimmten Häufigkeit oder bis die vorbestimmten Testkriterien erfüllt sind.

21. Verfahren nach einem der vorhergehenden Ansprüche, wobei die vorbestimmten Testkriterien erfüllt sind, wenn der Satz ausgewählter Testmuster mit einer mittleren Fitneß über einen vorbestimmten Wert assoziiert ist.

22. Verfahren nach einem der vorhergehenden Ansprüche, wobei Schritt (E) folgendes umfaßt:

Kombinieren einiger oder aller der ausgewählten Testmuster gemäß dem genetischen Algorithmus zum Bereitstellen des neuen Satzes Testmuster.

23. Verfahren nach Anspruch 22, weiterhin umfassend:

Auswählen von Testmustern aus dem Satz ausgewählter Testmuster gemäß vorbestimmter Auswahlkriterien und

Kombinieren der ausgewählten Testmuster gemäß dem genetischen Algorithmus zum Bereitstellen des neuen Satzes von Testmustern.

24. Verfahren nach Anspruch 23, umfassend:

Auswählen eines Testmusters, wenn es mit einem Fitneßwert größer als einem Referenzwert assoziiert ist.

25. Verfahren nach Anspruch 23 oder 24, umfassend:

(G) Auswählen eines Testmusters, wenn es mit einem höchsten Fitneßwert aller nicht ausgewählten Testmuster assoziiert ist.

26. Verfahren nach Anspruch 25, umfassend:

Wiederholen von Schritt (G), bis ein vorbestimmter Prozentsatz Testmuster ausgewählt worden ist.

27. Verfahren nach Anspruch 25, wobei Schritt (E) folgendes umfaßt:

(H) Anordnen der ausgewählten Testmuster in der Reihenfolge der assoziierten Fitneßwerte;
(I) zufälliges Auswählen von Stammtestmustern aus den Testmustern wie in Schritt (H) angeordnet und
(J) Kombinieren der ausgewählten Stammtestmuster.

28. Verfahren nach einem der vorhergehenden Ansprüche, wobei der genetische Algorithmus Überkreuzen, Rekombination und/oder Mutation ausgewählter Testmuster beinhaltet.

29. Verfahren nach einem der vorhergehenden Ansprüche, wobei Schritt (A) folgendes umfaßt:

Bereitstellen mehrerer Sätze ausgewählter Testmuster, wobei jeder Satz ausgewählter Testmuster in einer Testmusterpopulation enthalten ist.

**30.** Verfahren nach Anspruch 29, umfassend:

Ausführen der Schritte von einem der Ansprüche für jede Population.

**31.** Datenverarbeitungssystem, umfassend Mittel zum Ausführen des Verfahrens nach einem der vorhergehenden Ansprüche.

**32.** Computerprogramm, umfassend Mittel zum Ausführen des Verfahrens nach einem der Ansprüche 1 bis 30 auf einem Datenverarbeitungssystem, wenn das System betrieben wird.

**Revendications**

**1.** Méthode de test d'un circuit intégré, la méthode comprenant :

- l'adaptation d'un réseau neuronal pour se rapprocher du comportement du circuit intégré dans laquelle

(a) un ensemble de configurations d'essai est appliqué au circuit intégré ;
(b) l'ensemble de configurations d'essai est également appliqué au réseau neuronal ;
(c) les sorties du circuit intégré et les sorties du réseau neuronal sont comparées ; et
(d) les paramètres du réseau neuronal sont adaptés pour se rapprocher du comportement du circuit intégré sur la base de la comparaison ;

- (m) par la suite, l'application de configurations d'essai supplémentaires au réseau neuronal adapté ;
- (n) le traitement de la sortie du réseau neuronal pour déterminer si des critères prédéterminés sont respectés ;
- la sélection des configurations d'essai supplémentaires qui respectent les critères prédéterminés ;
- (A) la fourniture d'un ensemble de configurations d'essai constitué par les configurations d'essai sélectionnées ;
- (B) l'application de l'ensemble de configurations d'essai sélectionnées au circuit intégré à l'aide d'un équipement de test automatique (ATE) ;
- (C) la détermination des sorties du circuit intégré ;
- (D) le traitement des sorties pour déterminer si des critères de test prédéterminés sont respectés ; et
- (E) en fonction de la détermination de l'étape (D), la production d'un nouvel ensemble de configurations d'essai sur la base de l'ensemble de configurations d'essai sélectionnées fourni par l'étape (A) à l'aide d'un algorithme génétique.

**2.** Méthode selon la revendication 1, dans laquelle l'ensemble de configurations d'essai et/ou les configurations d'essai sélectionnées sont appliquées au circuit intégré par le biais d'un équipement de test automatique.

**3.** Méthode selon la revendication 2, dans laquelle le réseau neuronal est implanté dans l'équipement de test automatique.

**4.** Méthode selon la revendication 1 ou 2, dans laquelle l'ensemble de configurations d'essai est généré sur une base aléatoire.

**5.** Méthode selon l'une quelconque des revendications précédentes, dans laquelle l'étape (d) comprend :

l'adaptation de poids inter-unités du réseau neuronal par rétropropagation.

**6.** Méthode selon l'une quelconque des revendications précédentes, comprenant :

la répétition des étapes (a) à (d) jusqu'à ce qu'un niveau d'adaptation de l'étape (d) tombe en-dessous d'une valeur prédéterminée.

**7.** Méthode selon la revendication 6, comprenant :

le stockage de données représentant des paramètres de réseau neuronal prédéterminés à l'issue de la répétition des étapes (a) à (d).

8. Méthode selon l'une quelconque des revendications précédentes, comprenant :

(o) la sélection pour stockage de la configuration d'essai sélectionnée si les critères prédéterminés sont respectés.

9. Méthode selon la revendication 8, comprenant :

la répétition des étapes (m) à (o) jusqu'à ce qu'un nombre prédéterminé de configurations d'essai sélectionnées ait été stocké.

10. Méthode selon la revendication 8 ou 9, dans laquelle les critères prédéterminés sont respectés si une valeur d'un paramètre prédéterminé d'une sortie de signal par le réseau neuronal en réponse à l'application de la configuration d'essai sélectionnée dépasse une valeur de référence.

11. Méthode selon la revendication 10, comprenant :

(p) l'application d'un ensemble supplémentaire de configurations d'essai sélectionnées au circuit intégré à l'aide d'un équipement de test automatique (ATE) ;
(q) la mesure des valeurs du paramètre prédéterminé de signaux de sortie générés par le circuit intégré en réponse à l'étape (p), dans laquelle les critères prédéterminés sont respectés si la valeur du paramètre prédéterminé de la sortie de signal par le réseau neuronal en réponse à l'application de la configuration d'essai sélectionnée dépasse la valeur de référence et toutes les valeurs mesurées à cette étape (q).

12. Méthode selon la revendication 11, dans laquelle l'ensemble supplémentaire de configurations d'essai est généré sur une base aléatoire.

13. Méthode selon l'une quelconque des revendications 10 à 12, dans laquelle le paramètre prédéterminé est un courant.

14. Méthode selon l'une quelconque des revendications 8 à 13, comprenant en outre :

(r) la production d'une population de configurations d'essai constituée par une pluralité de configurations d'essai ;
(s) l'application de chaque configuration d'essai de la population de configurations d'essai au réseau neuronal ;
(t) pour chaque configuration d'essai, le traitement de la sortie du réseau neuronal pour déterminer une valeur d'un paramètre prédéterminé ;
(u) l'affectation de chaque configuration d'essai à l'un d'une pluralité de groupes de classification en fonction de la valeur du paramètre prédéterminé déterminée à l'étape (t).

15. Méthode selon la revendication 14, comprenant :

la répétition des étapes (r) à (u) en utilisant une nouvelle population de configurations d'essai constituée par les configurations d'essai incluses dans un groupe sélectionné parmi les groupes de classification.

16. Méthode selon la revendication 15, dans laquelle le groupe sélectionné parmi les groupes de classification est constitué de configurations d'essai qui se rapprochent d'un ensemble de paramètres d'entrée de fonctionnement dans le cas le plus défavorable du circuit intégré.

17. Méthode selon l'une quelconque des revendications 8 à 16, comprenant :

la répétition des étapes (m) à (o) plusieurs fois ;
l'application des configurations d'essai sélectionnées à chaque étape (o) au circuit intégré à l'aide d'un équipement de test automatique (ATE) ;
le traitement de la sortie de l'équipement de test automatique pour déterminer si des critères prédéterminés supplémentaires sont respectés ; et
la sélection pour stockage des configurations d'essai qui respectent les critères prédéterminés supplémentaires.

18. Méthode selon l'une quelconque des revendications précédentes, dans laquelle les critères prédéterminés représentent une approximation d'un mode de fonctionnement dans le cas le plus défavorable du circuit intégré.

**19.** Méthode selon l'une quelconque des revendications précédentes, comprenant :

(F1) la répétition des étapes (B) à (E) jusqu'à ce que les critères de test prédéterminés soient respectés.

**20.** Méthode selon l'une quelconque des revendications précédentes, comprenant :

(F2) la répétition des étapes (B) à (E) un nombre prédéterminé de fois ou jusqu'à ce que les critères de test prédéterminés soient respectés.

**21.** Méthode selon l'une quelconque des revendications précédentes, dans laquelle les critères de test prédéterminés sont respectés si l'ensemble de configurations d'essai sélectionnées est associé à une adaptation moyenne supérieure à une valeur prédéterminée.

**22.** Méthode selon l'une quelconque des revendications précédentes, dans laquelle l'étape (E) comprend :

la combinaison de certaines ou de toutes les configurations d'essai sélectionnées en fonction de l'algorithme génétique pour fournir le nouvel ensemble de configurations d'essai.

**23.** Méthode selon la revendication 22, comprenant en outre :

la sélection de configurations d'essai en dehors de l'ensemble de configurations d'essai sélectionnées en fonction de critères de sélection prédéterminés ; et
la combinaison des configurations d'essai sélectionnées en fonction de l'algorithme génétique pour fournir le nouvel ensemble de configurations d'essai.

**24.** Méthode selon la revendication 23, comprenant :

la sélection d'une configuration d'essai si elle est associée à une valeur d'adaptation supérieure à une valeur de référence.

**25.** Méthode selon la revendication 23 ou 24, comprenant :

(G) la sélection d'une configuration d'essai si elle est associée à une valeur d'adaptation la plus élevée de toutes les configurations d'essai non sélectionnées.

**26.** Méthode selon la revendication 25, comprenant :

la répétition de l'étape (G) jusqu'à ce qu'un pourcentage prédéterminé de configurations d'essai ait été sélectionné.

**27.** Méthode selon la revendication 25, dans laquelle l'étape (E) comprend :

(H) l'organisation des configurations d'essai sélectionnées dans l'ordre de valeurs d'adaptation associées ;
(I) la sélection aléatoire de configurations d'essai parentes en dehors des configurations d'essai telles qu'organisées à l'étape (H) ; et
(J) la combinaison des configurations d'essai parentes sélectionnées.

**28.** Méthode selon l'une quelconque des revendications précédentes, dans laquelle l'algorithme génétique comprend un enjambement, une recombinaison et/ou une mutation de configurations d'essai sélectionnées.

**29.** Méthode selon l'une quelconque des revendications précédentes, dans laquelle l'étape (A) comprend :

la fourniture d'une pluralité d'ensembles de configurations d'essai sélectionnées, chaque ensemble de configurations d'essai sélectionnées étant inclus dans une population de configurations d'essai.

**30.** Méthode selon la revendication 29, comprenant :

la réalisation des étapes selon l'une quelconque des revendications pour chaque population.

31. Système de traitement de données, comprenant un moyen pour appliquer la méthode selon l'une quelconque des revendications précédentes.

32. Programme informatique, comprenant un moyen pour appliquer la méthode selon l'une quelconque des revendications 1 à 30 sur un système de traitement de données, lors de l'exécution du système.

Group A

Bad Combination

Group B

Good Combination

Group C

Excellent Combination
**sub-optimal set**

Full Range Combination

*Fig. 1*

```
┌─────────────────────────────────────────┐
│ Neural Network                           │
│ Automatic input/output range determination│
│ (A set of random pattern)                │
└─────────────────────────────────────────┘
                    │
                    ▼
┌──────────────────┐   ┌──────────────────────────┐
│ ATE Test System  │◄──│ Random Pattern Generation│◄──┐
│ (RSMA)           │   │ (VSMC_VCM + DVMA)        │   │
└──────────────────┘   └──────────────────────────┘   │
         │                        │                    │
         ▼                        ▼                    │
┌──────────────────┐   ┌──────────────────────────┐   │
│ NN output coding │   │ NN input coding          │   │
└──────────────────┘   └──────────────────────────┘   │
         │                        │                    │
         │                        ▼                    │
         │             ┌──────────────────────────┐    │
         │             │ Neural Network (back-propagation)│ │
         │             └──────────────────────────┘    │
   NN Supervised            NN Learning          No    │
         │                        │                    │
         │                        ▼                    │
         └──────────►┌──────────────────────────┐──────┘
                     │ Neural Network Learning Error? │
                     └──────────────────────────┘
                                  │
                                Yes
                                  │
                                  ▼
                     ┌──────────────────────────┐
                     │ Plot Final NN Learning Result│
                     │ Final NN weight (brain) file Generation│
                     └──────────────────────────┘
```

**Neural Network Code Propagation**

Fig. 2

```
┌─────────────────────────────┐
│  NN weight (brain) File Input│
└─────────────────────────────┘
              │
              ▼
┌─────────────────────────────┐
│      NN input coding         │
└─────────────────────────────┘
              │
              ▼
┌─────────────────────────────┐
│  Random Pattern Generation   │
│      (VSMC_VCM)              │
└─────────────────────────────┘
              │
              ▼
┌─────────────────────────────┐
│     Neural Network           │
│  (Maximum Approximation)     │
└─────────────────────────────┘
              │
              ▼
┌─────────────────────────────┐
│     NN Decision Found?       │
└─────────────────────────────┘
              │ Yes
              ▼
┌─────────────────────────────┐
│     ATE Test System          │
│     DVMA + RSMA              │
└─────────────────────────────┘
              │
              ▼
┌─────────────────────────────┐
│ Better dynamic current detected?│
└─────────────────────────────┘
              │ Yes
              ▼
┌─────────────────────────────┐
│  Update pattern to VCM File  │
│      (DATABASE 1)            │
└─────────────────────────────┘
              │
              ▼
┌─────────────────────────────┐
│    End of searching loop     │
└─────────────────────────────┘
              │ Yes
              ▼
┌─────────────────────────────┐
│  Plot Final NN_MA Result     │
│  Final VCM file Generation   │
│  (Final Database 1 Generation)│
└─────────────────────────────┘
```

No

No

No

Fig. 3

Loop 2

| ATE Test System |
| --- |
| VSMC_VCM (Random Pattern Generator) : pattern population |
| DVMC + RSMA (Peak & Averaged Dynamic Current Measurement) |

New Pattern Population Generation

*Genetic Algorithm*

GA Fixness = Average (peak/averaged current) of population

Loop 1

Mutation                                    Selection

Re-Combination  ◄────  Cross Over

No

| End of GA Searching Loop 1? |
| --- |
| GA Fixness = Expected value? |

No

Yes

| End of Searching Loop 2? |
| --- |
| (New Pattern Population Generation) |

Yes

| Plot Final Analysis Results |
| --- |
| Final Analysis Report Generation |
| Final Worst Case Pattern Detected & File Generation |

*Fig. 4*

NN weight (brain) File Input

NN input coding

Random Pattern Generation
(VSMC_VCM) + ATE

No

Neural Network
(Maximum Approximation)

NN Decision Found?

Yes (New NN Sub-Optimal Pattern Population)

Genetic Algorithm
(Searching Loop 1)

No

End of Searching Loop 2?
(New Pattern Population?)

Yes

Plot Final NN_GA Analysis Result
Final Worst Case VCM File (Database 1) Generation

Fig. 5